# EUROPEAN PATENT APPLICATION

(11) **EP 0 863 609 A2**
(43) Date of publication of application: **09.09.1998**
(21) Application number: 98301602.3
(22) Date of filing: 04.03.1998
(51) Int. Cl.: H03G 1/00

(54) **Amplifier circuits**

(30) Priority: 05.03.1997 JP 50293/97
(71) Applicant: SONY CORPORATION, Tokyo 141 (JP)
(72) Inventor: Hirabayashi, Atsushi, c/o Sony Corporation, Shinagawa-ku, Tokyo 141 (JP); Fujita, Kosuke, c/o Sony Corporation, Shinagawa-ku, Tokyo 141 (JP); Komori, Kenji, c/o Sony Corporation, Shinagawa-ku, Tokyo 141 (JP); Murayama, Norihiro, c/o Sony Corporation, Shinagawa-ku, Tokyo 141 (JP)
(74) Representative: Pilch, Adam John Michael

(57) **Abstract**

An impedance (2) of a value 2·Z_{E} is connected in series between the emitters of differential pair transistors (1a), (1b) and these emitters are grounded by way of current sources (3a), (3b) respectively. Input signal sources (4a), (4b) of voltage values ±V_{IN} are connected to the bases of the transistors (1a), (1b) by way of the base-emitter paths of transistors (5a), (5b) which form a buffer circuit (10). The emitters of the transistors (5a), (5b) are in turn grounded by way of current sources (6a), (6b) respectively. Further, the collector of each transistor (1a), (1b) is connected to the base of the other transistor (1b), (1a) by way of the base-emitter paths of the transistors (5a), (5b) respectively.

## Description

The present invention relates to an amplifier circuit which may be suitable for use as a high frequency amplifier, a high gain amplifier or the like, and which may be used, for example, in a radio receiver, a television receiver, a satellite broadcasting receiver, a video recorder, a mobile communication apparatus or the like.

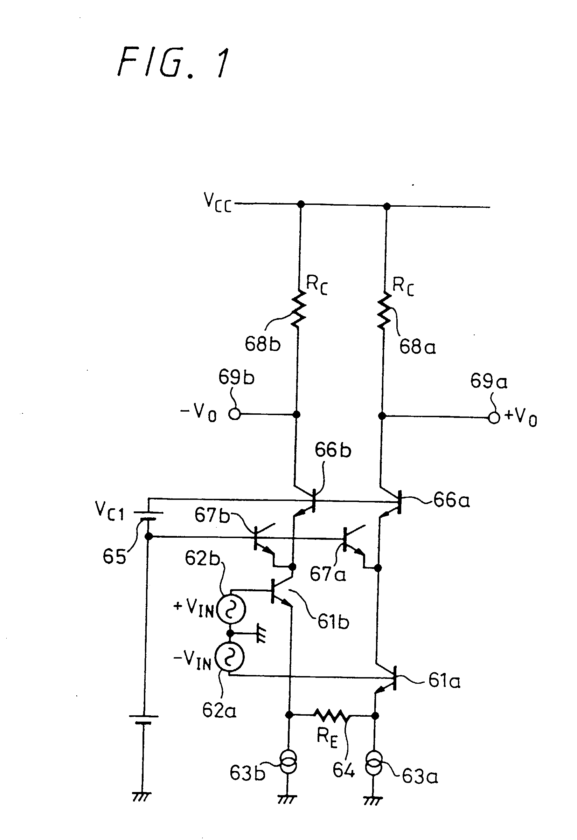

In a high frequency circuit and a high gain amplifier circuit which may be used, for example, in a television receiver, a gain control amplifier circuit, for example as shown in FIG. 1 of the accompanying drawings has been used. In other words, FIG. 1 shows the arrangement of a gain control amplifier circuit.

In FIG. 1, there is provided a differential pair consisting of transistors 61a, 61b and input signal sources 62a, 62b of voltages ±V_{IN} are connected to the bases of these transistors 61a, 61b respectively. The emitters of the transistors 61a, 61b are grounded by way of current sources 63a, 63b and an emitter resistor 64 of a resistance value R_{E} is connected between these emitters.

A current control circuit consisting of transistors 66a, 66b, 67a, 67b which are controlled by a control voltage source 65 of voltages ±V_{C} is connected to the collectors of the transistors 61a, 61b. The collectors of the transistors 66a, 66b in this current control circuit are connected to a voltage source V_{CC} by way of collector resistors 68a, 68b of a resistance value R_{C} and output signal terminals 69a, 69b of voltages ±V₀ are lead out from the collectors of the transistors 66a, 66b.

By the way, in the gain control amplifier as shown in FIG. 1, the maximum gain thereof is determined by the ratio of the resistance value R_{C} of the collector resistors 68a, 68b to the resistance R_{E} of the emitter resistor 64. Moreover, the maximum S/N is determined by the resistance value R_{C} of the collector resistors 68a, 68b.

Firstly, an explanation will be made in connection with the maximum gain. If the resistance value R_{C} of the collector resistors 68a, 68b is selected to be made larger to get a gain in the above mentioned circuit, a low pass filter (LPF) will be formed due to the floating capacities existing in the collectors of the transistors 66a, 66b. Accordingly, the frequency characteristic of the circuit will be deteriorated and hence it is difficult to get a sufficient gain at a desired frequency.

However, if the resistance value R_{C} of the collector resistors 68a, 68b is selected to be made smaller in order to extend the frequency characteristic, the gain is lowered. Accordingly, it is necessary to decrease the resistance value R_{E} of the emitter resistor 64. In this case, however, as a result, it is necessary to increase the bias current because an input dynamic range should be ensured. In that case, the load resistance should be re-estimated because of the limitations of the power source voltage.

The reason for the above effect is that the gain, the frequency characteristic and input/output dynamic ranges are related with one another to cause the degree of freedom of design to be narrower. The maximum S/N is in such a state that the gain is throttled because of the high input level, but in the past it was difficult to achieve the improvement of the S/N because the load resistance of the amplifier circuit has not been made variable.

Because of the above reasons, in the gain control circuit, it has been necessary to connect multi-steps of amplifier circuits in cascade in order to obtain a suitable gain and as a result, it has caused deterioration of S/N and DG DP and increase of the power consumption.

According to the present invention, a negative impedance circuit is formed by feeding back an impedance connected between the emitters of a differential pair by way of a voltage-current converting circuit in current-feedbacked to a path between the collectors, whereby a negative amplifier circuit can be formed using such the negative impedance circuit.

A preferred embodiment of the present invention may overcome the problem that in the previously-proposed gain control amplifier circuit, the freedom of design is narrow because the gain, the frequency characteristic and the like are related to one another and it is necessary to connect multi-steps of amplifier circuits in cascade to obtain the necessary gain which will cause deterioration of S/N, increase of the power consumption and the like.

The invention will now be described by way of example with reference to the accompanying drawings, throughout which like parts are referred to by like references, and in which:
FIG. 1 is a diagram of the arrangement of a gain control amplifier circuit;
FIG. 2 is a diagram of an example of the arrangement of a negative impedance generating circuit to which the present invention may be applied;
FIG. 3 is a diagram of an example of the arrangement of a negative capacitance generating circuit to which the present invention may be applied;
FIG. 4 is a diagram of an example of the arrangement of a negative resistance generating circuit to which the present invention may be applied;
FIG. 5 is a diagram of an example of the arrangement of a collector floating capacity cancelling circuit to which the present invention may be applied; and
FIG. 6 is a diagram of an example of the arrangement of a gain control amplifier circuit to which the present invention may be applied.

In embodiments of the present invention, a differential pair is provided, a voltage-current converting conductance in formed by connecting an impedance between the emitters of the differential pair, and collector outputs of the differential pair are fed back to the base inputs of the other ones mutually to thereby current-feedback a conductance connected between the emitters to a collector load as a negative impedance, so that a negative impedance is produced as an input impedance as seen from the collector sides of the differential pair.

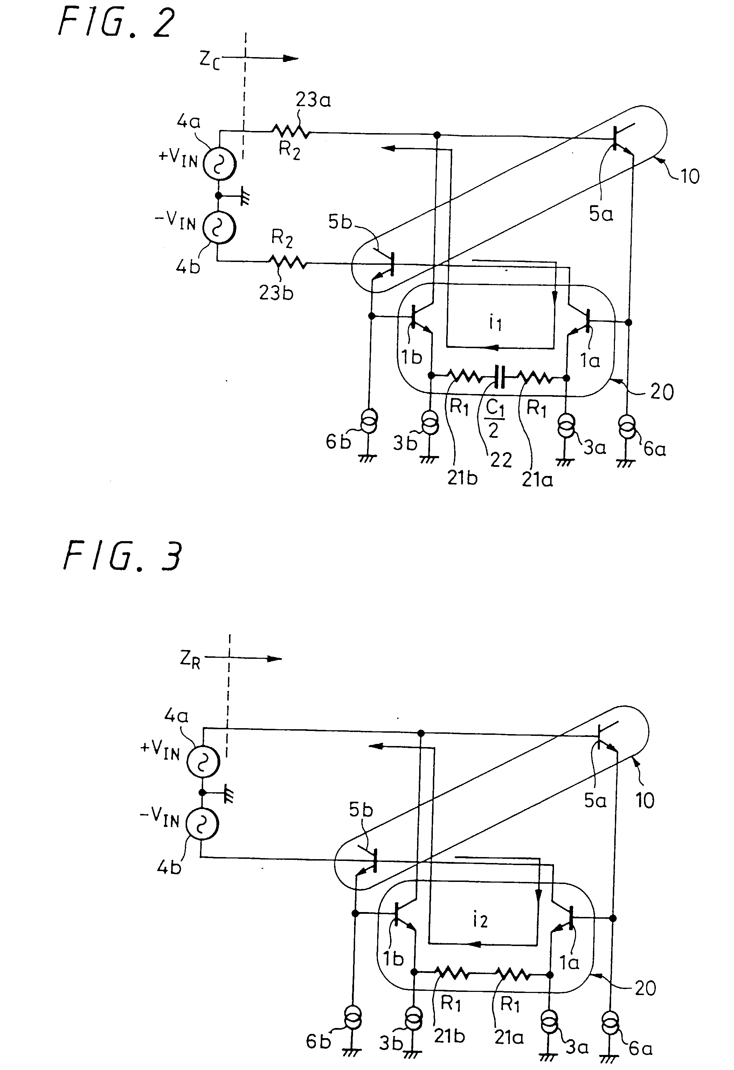

Hereinafter, the present invention will be described with reference to the drawings. FIG. 2 is a connection diagram showing an example of the arrangement of a negative impedance generating circuit to which the negative amplifier circuit according to the present invention is applied.

In FIG. 2, a differential pair consisting of transistors 1a, 1b are provided. Between the emitters of these transistors 1a, 1b an impedance 2 of value 2Z_{E} is connected in series and the emitters are grounded by way of current sources 3a, 3b, respectively.

Input signal sources 4a, 4b of voltages ±V_{IN} are respectively connected to the bases of the transistors 1a, 1b by way of the base-emitter paths of transistors 5a, 5b which forms a buffer circuit 10. The emitters of the transistors 5a, 5b are grounded by way of current sources 6a, 6b, respectively. The collectors of the transistors 1a, 1b are mutually connected to the bases of the other transistors 1a, 1b by way of the base-emitter paths of the transistors 5a, 5b respectively.

Accordingly, in the above circuit, input signals of voltages ±V_{IN} from the input signal sources 4a, 4b are supplied to the bases of the transistors la, 1b by way of the buffer circuit 10 formed of the transistors 5a, 5b respectively. A voltage-current converting circuit 20 is formed so as to convert the applied voltage ±V_{IN} into a current i₁. Meanwhile, the buffer circuit 10 also acts to perform a direct-current shift and to increase the input impedance to the bases of the transistors 1a, 1b.

In this circuit, an input impedance Z_{IN} as seen from the input signal source 4a, for example, of voltage +V_{IN} is expressed by the following equation 1.${\text{Z}}_{\text{IN}} \text{=} \frac{{\text{V}}_{\text{IN}}}{{\text{- i}}_{\text{1}}} \text{= ZE}$

Accordingly, in the circuit of FIG. 2, equivalently an impedance value -Z_{E} of the impedance 2 exists in series to the input signal of the voltage value +V_{IN} and equivalently a negative impedance is produced to thereby be able of forming a negative impedance generating circuit.

FIG. 3 shows an example of the arrangement of a negative capacitance generating circuit which is made as an application of the negative impedance circuit (a negative amplifier circuit) of FIG. 1. In the following description, the portions of FIG. 3 corresponding to those of the above mentioned circuit of FIG. 2 are designated by the same reference symbols to omit overlapped descriptions thereof.

In FIG. 3, the negative capacitance generating circuit is composed such that resistors 21a, 21b of a resistance value R₁ as the above mentioned impedance 2 and a capacitance 22 of a capacity value C₁ /2 are connected in series between the emitters of the transistors 1a, 1b which compose the differential pair of the negative impedance generating circuit as described above. Further, resistors 23b, 23a of a resistance value R₂ are symmetrically connected to the collectors of the transistors 1a, 1b respectively.

In this case, an input impedance Z_{IN} as seen from the input signal source 4a, for example, of the voltage value +V_{IN} is expressed by the following equation 2, if the value of the current flowing through the capacitance 22 is i₁.${\text{Z}}_{\text{IN}} \text{=} \frac{{\text{V}}_{\text{IN}}}{{\text{- i}}_{\text{1}}} {\text{= R}}_{\text{1}} {\text{- R}}_{\text{2}} \text{-} \frac{\text{1}}{{\text{SC}}_{\text{1}}}$

In the circuit of FIG. 3, if it is assume that R₁ = R₂, then${\text{Z}}_{\text{IN}} {\text{= -1 / (SC}}_{\text{1}} \text{)}$ is established.

Accordingly, the input impedance Z_{IN} includes only a negative capacitance so that a negative capacitance generating circuit can be formed.

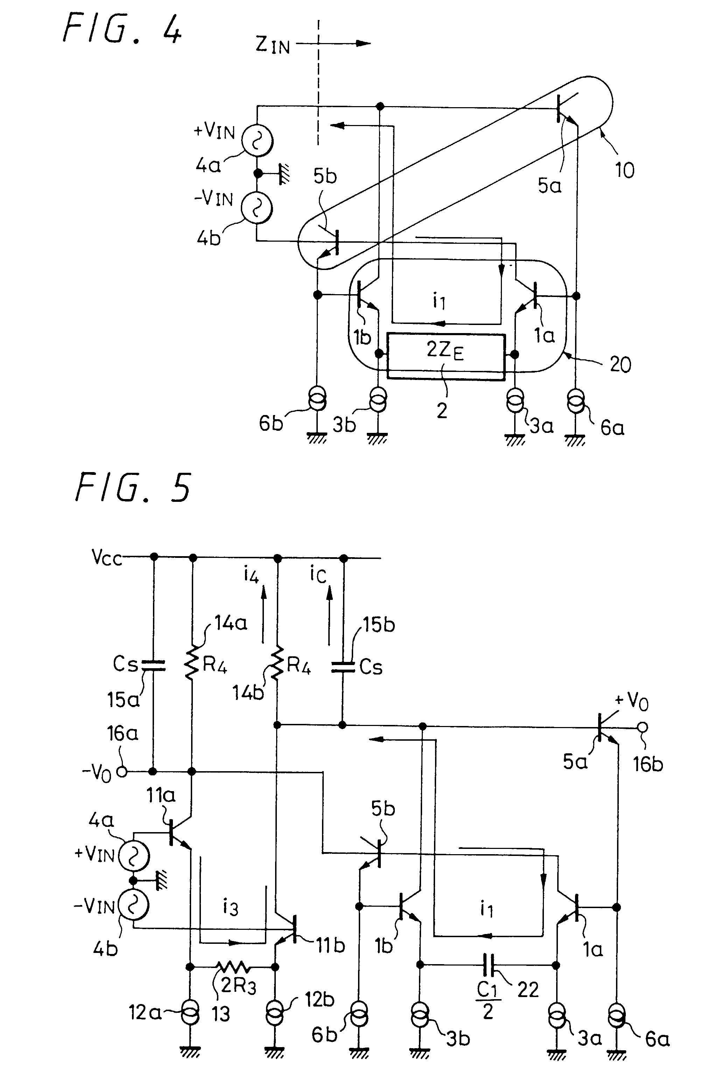

Further, FIG. 4 shows an example of the arrangement of a negative resistance generating circuit which is made as an application of the negative impedance circuit (a negative amplifier circuit) of FIG. 2. In the following description, the portions of FIG. 4 corresponding to the circuits of FIG. 2 and FIG. 3 are designated by the same reference symbols to omit overlapped descriptions thereof.

In FIG. 4, the negative resistance generating circuit is so composed that the resistors 21a, 21b of the resistance value R₁ as the impedance 2 are connected in series between the emitters of the transistors 1a, 1b which form the differential pair of the above mentioned negative impedance generating circuit.

In this case, an input impedance Z_{IN} as seen from the input signal source 4a, for example, of the voltage value +V_{IN} is expressed by the following equation 3, if the value of the current flowing through the resistors 21a, 21b is i₂.${\text{Z}}_{\text{IN}} \text{=} \frac{{\text{V}}_{\text{IN}}}{{\text{- i}}_{\text{2}}} {\text{= - R}}_{\text{1}}$

Accordingly, in the circuit of FIG. 4, equivalently an impedance value -R₁ of the impedance 2 exists in series to the input signal of the voltage value +V_{IN} and equivalently a negative resistance is produced so that a negative resistance generating circuit can be formed.

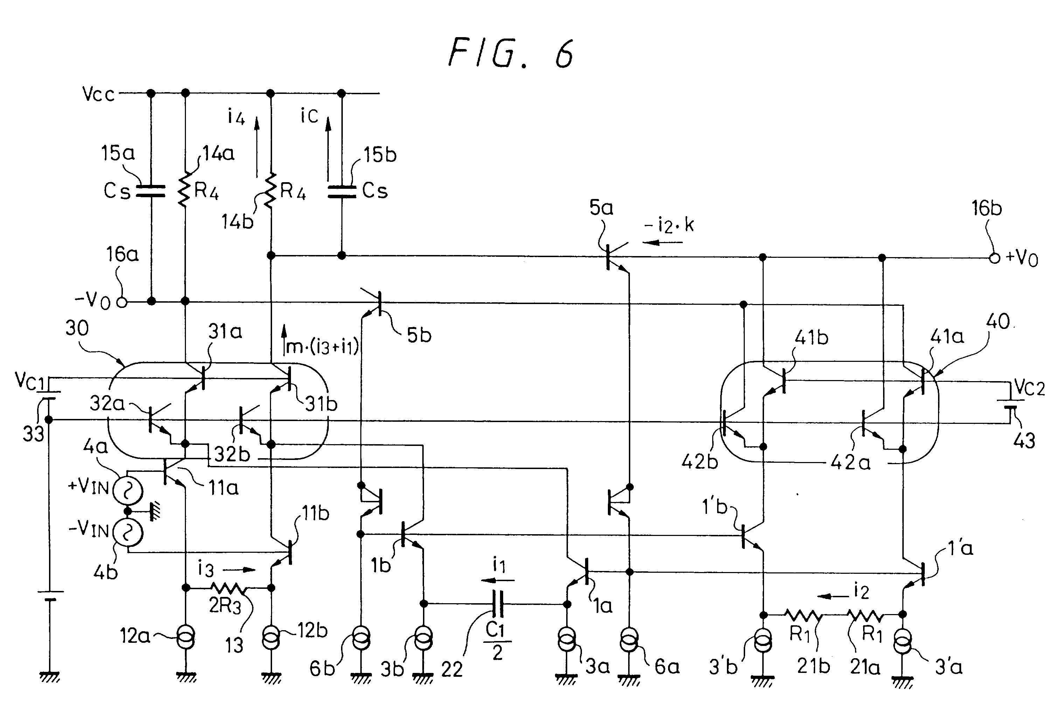

FIG. 5 shows an example of the negative amplifier circuit according to the present invention, in which a collector floating capacity canceling circuit is formed as an application of the negative capacitance generating circuit of FIG. 3. In the following description, the portions of FIG. 5 corresponding to those of the circuits shown in FIG. 2, FIG. 3 and FIG. 4 are designated by the same reference symbols to omit overlapped descriptions thereof.

The collector floating capacity canceling circuit is formed, for example, by adding the negative capacitance generating circuit of FIG. 3 as a load to the differential amplifier circuit. However, in the following description, the resistors 21a, 21b, 23a, 23b shown in FIG. 3 are omitted assuming that the resistances R₁, R₂ are equal.

Specifically, in FIG. 5, input signal sources 4a, 4b of voltage values ±V_{IN} are connected to the bases of transistors 11a, 11b respectively which form a differential pair. The emitters of the transistors 11a, 11b are grounded by way of current sources 12a, 12b, respectively, and an emitter resistor 13 of a resistance 2R₃ is connected in series between the emitters of the transistors 12a, 12b.

Further, the collectors of the transistors 11a, 11b are connected to a power source V_{CC} by way of collector resistors 14a, 14b of a resistance value R₄ respectively to form a differential amplifier. Capacitors 15a, 15b of a capacity value C_{S} shown in FIG. 5 are a total sum of the collector floating capacities which have originally existed in the transistors la, 1b of the negative capacitance generating circuit and the transistors 11a, llb of the differential amplifier.

The output voltage values ±V₀ which are obtained at output terminals 16a, 16b of the collectors of the transistors 11a, 11b are expressed by the following equation 4, wherein the is taken as i₄.$\frac{{\text{V}}_{\text{0}}}{{\text{R}}_{\text{4}}} {\text{+ V}}_{\text{0}} {\text{· SC}}_{\text{S}} {\text{- V}}_{\text{0}} {\text{· SC}}_{\text{1}} \text{=} \frac{{\text{V}}_{\text{IN}}}{{\text{R}}_{\text{3}}}$

That is, in this circuit, a negative capacity (-C₁) is added in parallel to the load resistors 14a, 14b by adding a negative capacitance generating circuit as a load.

Accordingly, in this circuit, if the capacities C_{S}, C₁ of the capacitors 15a, 15b which are floating capacities and the capacitance 22 are equal, the collector floating capacities can be apparently canceled. Accordingly, the usable frequency band of the differential amplifier can be widened and at the same time a larger gain can be obtained by making a load resistance larger. Namely, if a predetermined gain should be obtained, the purpose can be achieved by a fewer stage as compared with the prior art.

FIG. 6 shows another example of the negative amplifier circuit according to the present invention, in which a gain control amplifier circuit is formed as an application of the negative capacitance generating circuit of FIG. 3 and the negative resistance generating circuit of FIG. 4. In the following description, the portions corresponding to the portions of the circuits in FIGS. 2 to 4 are designated by the same reference symbols to omit overlapped repeated descriptions thereof.

The gain control amplifier circuit is composed of the thereof.

The gain control amplifier circuit is composed of the negative resistance generating circuit shown in FIG. 4, a current control circuit 30 consisting of transistors 31a, 31b, 32a, 32b and a current control circuit 40 consisting of transistors 41a, 41b, 42a, 42b in addition to the collector floating capacity canceling circuit shown in FIG. 5.

As shown in FIG. 6, the current control circuit 30 consisting of the transistors 31a, 31b, 32a, 32b which are controlled by a control voltage source 33 of voltage values ±V_{C1} is connected between the collectors of the transistors 11a, 11b of the differential amplifier and the collector resistors 14a, 14b of the resistance value R₄. Here, the current flowing through the resistor 13 is assumed to be i₃.

A differential pair consisting of transistors 1'a, 1'b whose bases are connected in common to the transistors 1a, 1b forming the negative capacitance generating circuit in the collector floating capacity canceling circuit are provided, and emitter resistors 21a, 21b of a resistance value R₁ are connected in series between the emitters of the transistors 1'a, 1'b to thereby form a negative resistance generating circuit.

Further, the collectors of the transistors 1'a, 1'b in the negative resistance generating circuit are connected in common to the bases of the output transistors 5a, 5b in the negative capacitance generating circuit by way of the current control circuit 40 consisting of the transistors 41a, 41b, 42a, 42b which are controlled by a control voltage source 43 of resistors 21a, 21b is assumed to be i₂.

In this circuit, if the output voltages ±V₀ obtained at the output terminals 16a, 16b are calculated, assuming that a coefficient applied by the current control circuit 30 is m and a coefficient applied by the current control circuit 40 is k, the voltage value V₀ is expressed by the following [equation (5)].

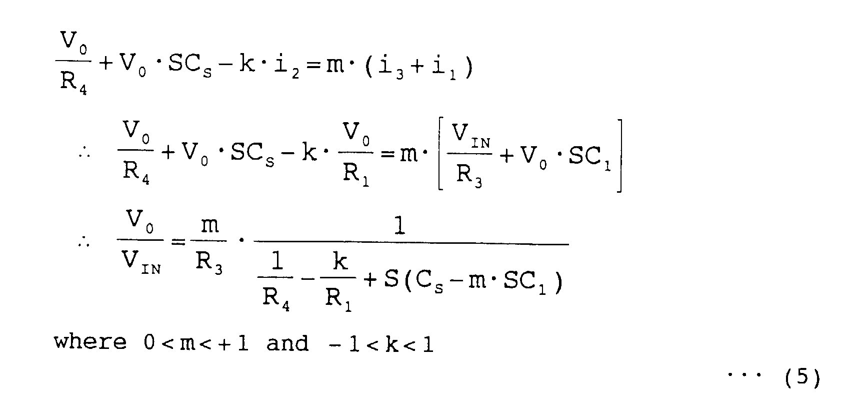

Specifically, from the [equation (5)], it can be seen that the load impedance of the gain control amplifier circuit is made of a parallel circuit consisting of the emitter resistors 21a, 21b whose resistance value is R₁ in the negative resistance generating circuit, the collector resistors 14a, 14b whose resistance value is R₄ in the gain control amplifier circuit, the floating capacities 15a, 15b whose capacity is C_{S} and the capacitor 22 whose capacity is C₁.

In this circuit, accordingly the load resistance is maximum when k = 1, and concurrently the condition R₁ > R₄ is necessary. This is because the output will reverse if this necessary. This is because the output will reverse if this relation is the reverse. It can be seen that if R1 is made close to R₄ with the condition of R₁ > R₄ being satisfied, the gain increases by the corresponding amount.

As the frequency characteristic will deteriorate due to the floating capacities when the maximum gain is to be obtained, it is necessary to cancel the capacity C_{S} of the floating capacities 15a, 15b by (m·C) which is obtained by controlling the coefficient m, and if C₁ = C_{S} is assumed, m = 1 should be realized when k = 1.

The range in which the m should be held to be 1 when the k is theoretically throttled corresponds to the extent where the frequency characteristic does not affect the frequencies to be used even if the collector floating capacities exist. However, in fact, considering the S/N, the load resistance should be throttled sufficiently and therefore m = 1 should be held while the k is throttled from 1 to -1 and then the m begins to be throttled.

Accordingly, the gain control amplifier embodying the present invention is characterized in that a delay system of the gain control which is applied to throttle first the k and then throttle the m exists in one stage amplifier. In the gain control amplifiers of the prior art, such a gain control that the subordinately connected amplifiers are delayed one another has existed, but such a gain control that the delay exists in one stage amplifier has not existed and has appeared first.

In the above mentioned circuit, the load resistance which is a noise source becomes a minimum and the S/N can be improved by throttling first the load resistance sufficiently and then throttling the current of the input differential amplifier.

According to the negative amplifier circuit embodying the present invention, a gain control amplifier circuit can be formed which uses a negative impedance circuit in which a pair of differential amplifiers are connected, particularly a negative capacitance circuit as a negative impedance circuit and a negative resistance.

Further, according to the negative amplifier circuit embodying the present invention, the floating capacities existing in the collectors of the transistors can be cancelled by equivalently forming the negative capacitance with the use of the negative impedance, and at the same time the load resistance of the amplifier can be made variable by equivalently forming the negative resistance with the use of the negative impedance.

According to the negative amplifier circuit embodying the present invention, the frequency characteristic of the amplifier can be improved and the gain per one stage of the amplifier can be increased. Accordingly, a high gain can be achieved by fewer stages of amplifiers as compared with the prior art and as a result, the improvement in the linearity of the amplifier circuit and the decrease of the noise can be realized.

Further, according to the negative amplifier circuit embodying the present invention, in case that the gain is throttled when the input level is high, the S/N can be improved remarkably by varying the negative resistance from minus to plus. Thus, it becomes possible that lower power consumption is achieved, performance is improved, the IC chip's area is reduced and the manufacturing cost is reduced significantly.

According to the circuit as set forth above, by forming a negative impedance generating circuit, various negative impedances can be produced within the silicon and a high impedance which has been considered difficult to produce in the prior art can be formed. Accordingly, a high gain amplifier circuit can be formed by a few number of components and a large capacity can be produced within an IC chip by the use of a small capacity, resulting in the decrease of the IC chip's area. Further, many advantages can be obtained such as the cutback of power consumption, the cost reduction of IC, it's manufacturing, and the decrease of the substrate area thereof.

Further, by forming a collector floating capacity cancelling circuit, the collector floating capacities which have always existed in transistors become virtually smaller, and hence the frequency band for the use of the amplifier circuits which use transistors can be largely widened. The load resistance can be increased by the corresponding amount of the decrease in the collector floating capacities and as a result the gain per one stage of the amplifier can be increased. Accordingly, a desired gain can be obtained by fewer components as compared with the prior art and the chip size of IC can be made smaller, resulting in advantages such as the improvements of IC characteristic, particularly, the S/N, the reductions of power consumption, the IC cost and the manufacturing cost, and the decrease of the substrate area.

Further, by forming a gain control amplifier circuit, the number of stages of the amplifier and the number of the components forming the circuit can be reduced when an amplifier of several tens of decibels is to be formed. Accordingly, it can sufficiently afford the improvement of the S/N as a characteristic, the reduction of power consumption, and the operation in a low voltage. Further, in the gain control amplifier circuit, the collector load resistance itself which has been a definite cause of the maximum S/N becomes small in the reduction of the gain and therefore the S/N can be improved by several decibels as compared with the prior art. Accordingly, the chip size of the IC can be made smaller, and advantages can be obtained such as the improvement of the characteristic of the IC, particularly, the S/N, the cutback of power consumption, the cutback of the cost of the IC and the cutback of its manufacturing effort, and the reduction of the substrate area.

A preferred embodiment of the present invention having been described with reference to the accompanying drawings, it is to be understood that the present invention is not limited to the above-mentioned embodiment and that various changes and modifications can be effected therein by one skilled in the art without departing from the scope of the present invention as defined in the appended claims.

## Claims

1. An amplifier circuit comprising:
a differential pair,
voltage-current converting conductance which is formed by connecting an impedance between emitters of said differential pair, and
a negative impedance generating circuit for generating a negative impedance as an input impedance as seen from the collector side of said differential pair, which is formed such that the conductance connected between said emitters is current-feedbacked to a collector load as a negative impedance by feeding collector outputs of said differential pair to bases of the other ones mutually.

2. An amplifier circuit according to claim 1, wherein a collector floating capacity cancelling circuit for cancelling a collector floating capacity of said differential pair is formed by connecting said negative impedance generating circuit to a collector load of a second differential pair to make said impedance as a capacitance.

3. An amplifier circuit according to claim 2, wherein a variable gain circuit for varying a gain from plus to minus is formed by connecting said collector floating capacity cancelling circuit to a collector load of said second differential pair, making an impedance of said second negative impedance generating circuit as a resistance and inserting a full-balance type current control circuit into a collector of said negative impedance generating circuit which uses the resistance.

4. An amplifier circuit according to claim 3, wherein a gain control amplifier circuit is formed by controlling said variable gain circuit.
